(19) Europäisches Patentamt / European Patent Office / Office européen des brevets

(11) **EP 4 701 058 A1**

(12) **DEMANDE DE BREVET EUROPEEN**

(43) Date de publication:
**25.02.2026 Bulletin 2026/09**

(21) Numéro de dépôt: **25194187.8**

(22) Date de dépôt: **05.08.2025**

(51) Classification Internationale des Brevets (IPC):
**H02M 1/12** *(2006.01)* **H03H 7/09** *(2006.01)*

(52) Classification Coopérative des Brevets (CPC):
**H02M 1/126; H03H 7/09**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **15.08.2024 FR 2408941**

(71) Demandeur: **Airbus Operations SAS**
**31060 Toulouse (FR)**

(72) Inventeurs:
• **BAREAUD, Patrick**
**31060 Toulouse (FR)**
• **SATHLER ZAPPULLA, Gustavo**
**31060 Toulouse (FR)**

(74) Mandataire: **BCF Global**
**17-21, rue Saint-Fiacre**
**75002 Paris (FR)**

(54) **FILTRE DE MODE DIFFÉRENTIEL À IMPÉDANCE VARIABLE**

(57) L'invention porte sur un filtre de mode différentiel comprenant une inductance variable, l'inductance variable comprenant un enroulement primaire (101) couplé à un enroulement secondaire (102), l'enroulement secondaire comprenant un interrupteur (103) monté en série, configurés pour que: lorsque l'interrupteur est en position fermée, l'inductance variable a une première valeur d'inductance, et lorsque l'interrupteur est en position ouverte, l'inductance variable a une seconde valeur d'inductance. La première valeur d'inductance est inférieure à la seconde valeur d'inductance.

**Fig. 1**

# Description

## Domaine

La présente invention concerne un filtre de mode différentiel à impédance variable, et plus particulièrement un filtre de mode différentiel comprenant un inducteur avec un circuit actif permettant de changer son inductance.

## Contexte

La conception d'applications critiques, par exemple de réseaux électriques des aéronefs, doit assurer que sur toutes les conditions d'utilisation le réseau reste stable.

Dans le contexte d'analyses de stabilité, un des critères le plus utilisé (parce que robuste pour des applications critiques) est le critère de Middlebrook.

De tels réseaux électriques comportent typiquement au moins deux convertisseurs en cascade. Des filtres de mode différentiel sont utilisés en entrée et en sortie de ces convertisseurs pour garantir notamment le filtrage des harmoniques liés aux fréquences de découpage. La topologie la plus utilisée est le filtre LC, sans ou avec amortissement, notamment trois principales configurations de filtre différentiel avec amortissement (RC parallèle, RL parallèle et RL série).

Néanmoins, quand les convertisseurs en cascade sont bidirectionnels, la garantie de stabilité par le critère de Middlebrook ne peut plus être démontrée avec des filtres traditionnels. Etant donné que l'impédance de sortie de l'équipement en amont doit être inférieure à l'impédance d'entrée de l'équipement en aval, lorsque la direction du flux de puissance change, l'équipement qui était une charge devient une source (et vice-versa), et cette exigence sur les valeurs respectives d'impédance n'est plus respectée.

Sans modification des profils des impédances suivant le mode d'opération (charge ou source), la stabilité en cas de convertisseurs bidirectionnels en cascade ne peut plus être démontrée selon le critère de Middlebrook.

Les techniques évoquées dans cette section ne doivent pas être présumées appartenir à l'état de la technique du seul fait de leur seule évocation. De même, un problème mentionné dans cette même section ne doit pas être présumé avoir été précédemment identifié dans l'état de la technique à raison de sa seule mention.

## Résumé

Des modes de réalisation de la présente invention ont été développés sur la base de la compréhension par les développeurs des lacunes associées à l'art antérieur. L'invention propose d'une manière générale, un filtre de mode différentiel qui varie son impédance, par exemple en fonction du mode d'opération "source" ou "charge" d'un équipement (par exemple un convertisseur), avec lequel il est utilisé. Le filtre de mode différentiel suivant l'invention comprend un inducteur avec un circuit actif qui permet de changer son inductance.

Plus particulièrement, la présente invention comporte, sous différents modes de réalisation, un filtre de mode différentiel comprenant une inductance variable, l'inductance variable comprenant un enroulement primaire couplé à un enroulement secondaire, l'enroulement secondaire comprenant un interrupteur monté en série, configurés pour que :

- lorsque l'interrupteur est en position fermée, l'inductance variable a une première valeur d'inductance, et lorsque l'interrupteur est en position ouverte, l'inductance variable a une seconde valeur d'inductance; et
- la première valeur d'inductance est inférieure à la seconde valeur d'inductance.

Dans un mode de réalisation du filtre, l'enroulement secondaire comprend en outre une première impédance additionnelle en série avec l'interrupteur.

Dans un autre mode de réalisation du filtre, l'enroulement secondaire comprend en outre une seconde impédance additionnelle en parallèle avec l'interrupteur et la première impédance additionnelle.

Dans un autre mode de réalisation du filtre, l'interrupteur est bidirectionnel.

Dans un autre mode de réalisation du filtre, l'interrupteur est de type électronique.

La présente invention comporte aussi, sous différents modes de réalisation, un réseau électrique comprenant deux convertisseurs bidirectionnels, un premier et un second, montés en cascade, le premier et second convertisseur bidirectionnel étant électriquement relié à respectivement un premier et un second filtre de mode différentiel comme ci-dessus, le premier filtre de mode différentiel étant électriquement relié au second filtre de mode différentiel, un premier et second interrupteur de respectivement le premier et second filtre de mode différentiel étant configurés pour que :

- lorsque le premier convertisseur bidirectionnel est en mode source, et le second convertisseur en mode charge : le premier interrupteur est fermé, et le second interrupteur est ouvert; et
- lorsque le second convertisseur est en mode source, et le premier convertisseur en mode charge : le second interrupteur est fermé, et le premier interrupteur est ouvert.

La présente invention comporte aussi, sous différents modes de réalisation, un aéronef comprenant le réseau électrique ci-dessus.

Dans le cadre de la présente description, sauf disposition expresse contraire, les mots "premier", "deuxième", "troisième", etc. n'ont été utilisés comme adjectifs qu'aux seules fins de permettre de distinguer les noms qu'ils accompagnent les uns des autres, et non dans le but de décrire une relation particulière entre ces noms.

Les mises en œuvre de la présente invention ont chacune au moins un des objets et/ou aspects mentionnés ci-dessus, mais ne les ont pas nécessairement tous.

Des caractéristiques, aspects et avantages supplémentaires et/ou alternatifs des mises en œuvre de la présente invention ressortiront de la description suivante, des dessins joints et des revendications annexées.

**Brève description des dessins**

Pour une meilleure compréhension de la présente invention, il est fait référence à la description suivante qui doit être utilisée conjointement avec les dessins ci-joints, où:

> **[Fig.1]** représente un schéma d'inductance avec circuit actif dans un mode de réalisation de l'invention;
> **[Fig.2]** représente un schéma de modélisation d'inductance avec enroulement secondaire équivalente à un transformateur;
> **[Fig.3]** représente des diagrammes de Bode associés à une simulation de l'inductance dans un mode de réalisation de l'invention;
> **[Fig.4]** représente des schéma d'inductance avec circuit actif dans d'autres modes de réalisation de l'invention; et
> **[Fig.5]** représente un aéronef comportant un exemple d'implémentation de réseau électrique mettant en oeuvre l'invention.

Il convient de noter que, sauf indication contraire explicite, les dessins ne sont pas à l'échelle. Enfin, les éléments identiques d'un dessin à l'autre portent la même référence numérique.

**Description des modes de réalisation**

Les exemples et les conditions associées détaillés ici sont principalement destinés à aider le lecteur à comprendre les principes de la présente invention et non à limiter sa portée à ces exemples et conditions spécifiques. On comprendra que l'homme du métier peut concevoir divers agencements qui, bien qu'ils ne soient pas explicitement décrits ou représentés ici, incarnent néanmoins les principes de la présente invention et sont inclus dans son esprit et sa portée.

En outre, pour faciliter la compréhension, la description suivante peut décrire des mises en œuvre relativement simplifiées de la présente invention. Comme l'homme du métier le comprend, d'autres mises en œuvre de la présente invention peuvent être d'une plus grande complexité.

Dans certains cas, des exemples de modifications de la présente invention peuvent également être présentés. Ceci est fait simplement comme une aide à la compréhension, et, à nouveau pas pour définir la portée ou établir les limites de la présente invention. Ces modifications ne sont pas une liste exhaustive, et l'homme du métier pourra apporter d'autres modifications tout en restant dans le cadre de la présente invention.

En outre, toutes les déclarations ci-après relatives aux principes, aspects et mises en œuvre de la présente invention, ainsi que les exemples spécifiques de celle-ci, visent à englober à la fois les équivalents structurels et fonctionnels de celle-ci, qu'ils soient actuellement connus ou développés à l'avenir. Ainsi, par exemple, il sera compris par l'homme du métier que tous les schémas fonctionnels représentent des vues conceptuelles d'exemples de circuits incorporant les principes de la présente invention.

Ceci étant posé, nous allons maintenant considérer quelques exemples non limitatifs pour illustrer diverses mises en œuvre de la présente invention.

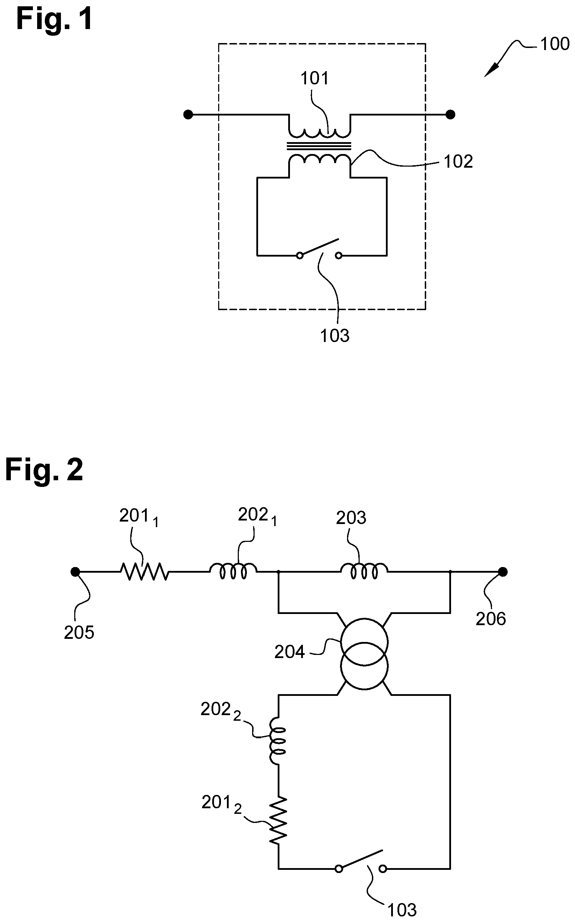

La Fig.1 représente un schéma d'inductance avec circuit actif 100 dans un mode de réalisation de l'invention.

Cet inductance peut notamment être utilisée dans les filtres de mode différentiel de type LC, mentionnés en introduction.

Elle comporte un enroulement primaire 101 couplé à un enroulement secondaire 102. Un interrupteur 103 permet, en position fermée, de créer un court-circuit sur l'enroulement secondaire 102.

Cette inductance avec enroulement secondaire 102 est équivalente à un transformateur qui peut être modélisé comme en Fig.2. Dans ce modèle, des inductances $202_1$ et $202_2$, correspondent respectivement à l'enroulement primaire 101 et à l'enroulement secondaire 102, de valeurs respectives données, et sont les inductances de dispersion due à la partie du flux magnétique qui ne se referme pas par le circuit magnétique.

Une inductance 203 est l'inductance de magnétisation du transformateur, qui a normalement une valeur élevée due à la perméabilité magnétique importante du noyau du transformateur, mais qui peut être maîtrisée par l'introduction d'un entrefer (ou de façon équivalente, par l'utilisation des matériaux magnétiques en poudre de fer avec entrefer distribué).

Des résistances $201_1$ et $201_2$, correspondant respectivement à l'enroulement primaire 101 et l'enroulement secondaire 102, et un transformateur 204, considéré comme un transformateur idéal, complètent ce modèle. Le courant circule entre les points 205 et 206 de l'équivalent de l'enroulement primaire 101. Seules les composantes alternatives de ce courant sont transmises à l'équivalent de l'enroulement secondaire 102.

Lorsque l'interrupteur 103 est ouvert, l'inductance équivalente dans le chemin de puissance du filtre est égale à la somme de l'inductance $202_1$ de dispersion du primaire et l'inductance de magnétisation 203 du transformateur. La somme de ces inductances peut être réglée par conception pour avoir l'inductance totale nécessaire requise pour le filtrage en mode différentiel quand l'équipement fonctionne en tant qu'une charge. Si les valeurs de résistance et d'inductance sont respectivement :

- résistance $201_1$ de l'enroulement primaire 101 = $R_{s1}$
- inductance de dispersion $202_1$ de l'enroulement primaire 101 = $L_{leak1}$
- inductance de magnétisation 203 de l'enroulement primaire 101 = $L_m$ alors la fréquence de coupure résultante (en Hz) par le composant dans cet état est obtenue par

l'Equation 1 :

$$f_{coupure} = R_{s1} / 2\pi \times (L_m + L_{leak1})$$

Lorsque l'interrupteur 103 est fermé, l'enroulement secondaire va créer un chemin de plus basse impédance pour les composantes alternatives du courant. Si la valeur de l'inductance de magnétisation 203 est considérablement plus élevée (de l'ordre de 10 fois) que celle de dispersion $202_2$ du secondaire, l'inductance équivalente du chemin de puissance pour les composantes alternatives peut être approximée par la somme entre les inductances de dispersion $202_1$ et $202_2$ des enroulements primaire et secondaire respectivement. Cette somme peut être réglée par conception pour avoir une valeur très faible, requise pour le filtrage en mode différentiel quand l'équipement fonctionne en tant que source. Si les valeurs de résistance et d'inductance sont respectivement :

- résistance $201_2$ de l'enroulement secondaire 102 = $R_{s2}$
- inductance de dispersion $202_2$ de l'enroulement secondaire 102 = $L_{leak2}$

alors la fréquence de coupure résultante (en Hz) pour le composant dans cet état est obtenue par
l'Equation 2 :

$$f_{coupure} = (R_{s1} + R_{s2}) / 2\pi \times (L_{leak1} + L_{leak2})$$

Pour démontrer l'efficacité de la solution de l'invention, il est présenté un diagramme de simulation obtenu en utilisant l'outil LTSpice™. Les valeurs de paramètres considérées sont par exemple :

$$R_{s1} = R_{s2} = 5mOhms$$

$$L_{leak1} = L_{leak2} = 5microH$$

$$L_m = 1000microH$$

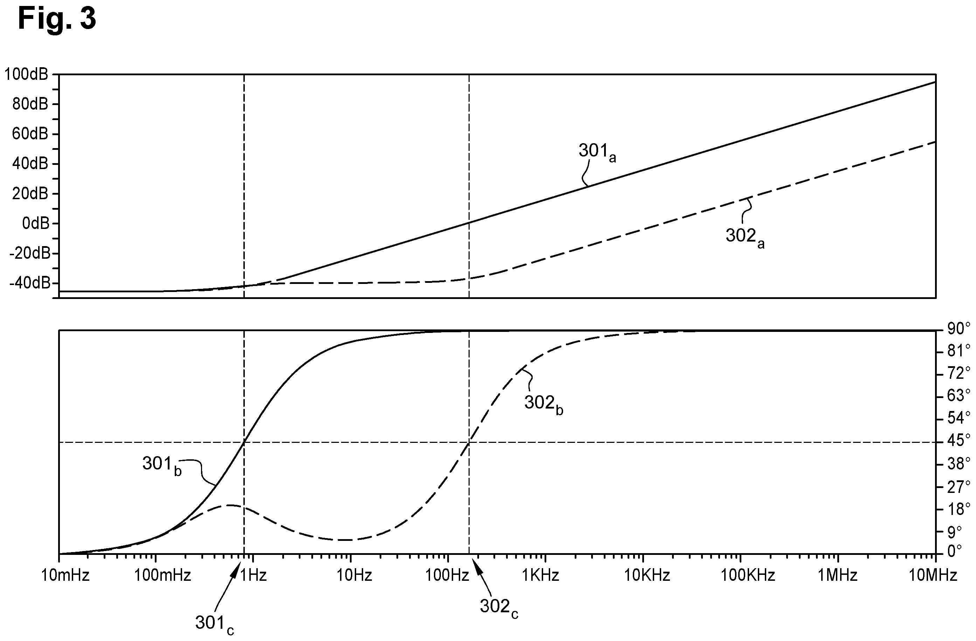

Les résultats sont montrés par les diagrammes de Bode en Fig.3.

Les courbes $301_a$ et $301_b$ représentent respectivement la magnitude et la phase, dans le cas où l'interrupteur 103 est en état ouvert. Les courbes $302_a$ et $302_b$ représentent respectivement la magnitude et la phase, dans le cas où l'interrupteur 103 est en état fermé.

L'inclinaison des courbes de magnitude $301_a$ et $302_a$ après les fréquences de coupure caractéristiques des deux systèmes sont de 20dB/déc, ce qui correspond à une réponse inductive comme attendue. Les fréquences de coupure ont été identifiées par les flèches $301_c$ et $302_c$ sur les courbes de phase $301_b$ et $302_b$, correspondant aux fréquences qui croisent la phase de 45°. Ainsi, la valeur de la fréquence de coupure calculée par l'Equation 1 ci-dessus est de 0,792Hz, qui est proche de la valeur $301_c$ de 0,794Hz résultant de la simulation. De même la valeur de la fréquence de coupure calculée par l'Equation 2 ci-dessus est de 159,1Hz, qui est proche de la valeur $302_c$ de 158,9Hz résultant de la simulation. Cette analyse démontre l'effectivité de la solution proposée.

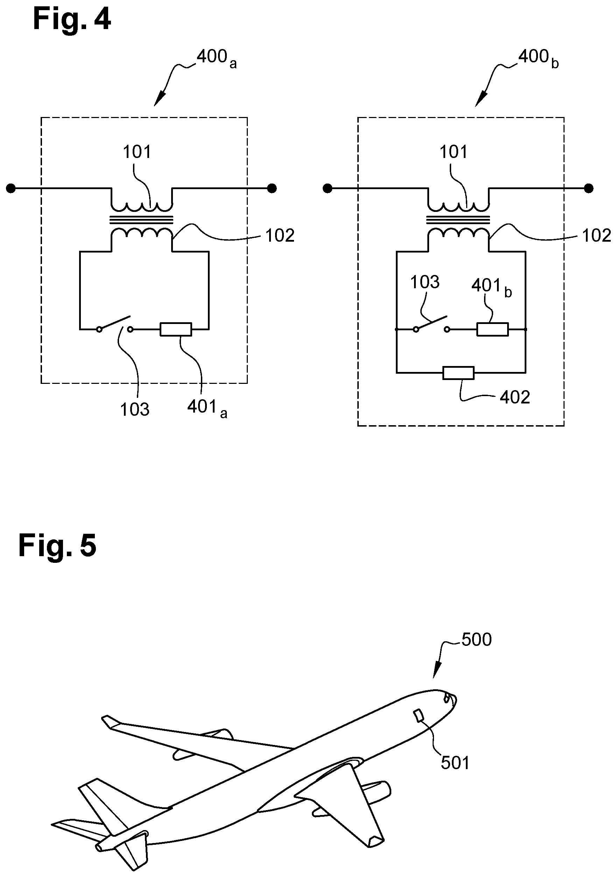

Des exemples de variantes $400_a$ et $400_b$ de schéma d'inductance avec circuit actif dans d'autres modes de réalisation de l'invention, sont proposés Fig.4. Ces inductances comportent également l'enroulement primaire 101 couplé à l'enroulement secondaire 102, tandis que l'interrupteur 103 permet, en position fermée, de créer un court-circuit sur l'enroulement secondaire 102. Par rapport au schéma d'inductance de la Fig.1, la variante $400_a$ comporte une impédance additionnelle $401_a$ en série avec l'interrupteur 103 dans le circuit d'enroulement secondaire 102. Par rapport à la variante $400_a$, la variante $400_b$ comporte également une impédance $401_b$ en série avec l'interrupteur 103, et une impédance additionnelle 402 en parallèle. Toutes ces variantes peuvent être analysées par l'homme du métier, de la même façon que l'analyse ci-dessus relative au schéma d'inductance de la Fig.1.

Quelle que soit la variante, l'invention permet d'utiliser les mêmes matériaux magnétiques (ferrite, poudre de fer, nanocristallin, amorphes), géométries de noyau, et technologies utilisées pour les filtres de mode différentiel conventionnels.

Dans le cas où les impédances de dispersion doivent être très réduites, il est nécessaire d'avoir un facteur de couplement important entre l'enroulement primaire et secondaire. Dans ce cas, des technologies de bobines entrelacées ou fils coaxiaux peuvent être préférables.

Le rapport de transformation entre les enroulements primaire et secondaire peut être choisi en fonction des niveaux de courant et tension alternatifs dans le domaine de la fréquence. Un rapport de transformation élevé permet d'utiliser un nombre faible de spires à l'enroulement secondaire et une tension également moins élevée, ce qui permet l'utilisation d'un interrupteur de capacité en tension plus faible. Néanmoins, le courant obtenu à l'enroulement secondaire sera plus important.

L'interrupteur 103 utilisé à l'enroulement secondaire est avantageusement bidirectionnel, étant donné que le courant qui va circuler est alternatif. Pour une question de rapidité, l'utilisation d'interrupteurs électroniques est préférable, basés sur les semiconducteurs (par exemple de type : transistor à effet de champ à grille isolée, transistor à effet de champ à dopage modulé, ou transistor à jonction bipolaire, respectivement : MOSFET, HEMT, BJT en langue anglaise). En fonction du rapport de spires, il est préférable d'utiliser des composants avec une faible chute de tension en état fermé (ou de façon équivalente, une faible résistance d'état passant), pour que le dispositif n'ajoute pas davantage d'éléments en série au système.

L'invention permet ainsi notamment de dynamiquement (ie : en cours d'opération) modifier l'impédance de filtres de mode différentiel associés à des convertisseurs bidirectionnels, en fonction du mode d'opération desdits convertisseurs en tant que source ou en tant que charge. Cela est nécessaire pour démontrer la stabilité des réseaux électriques critiques par critère de Middlebrook, critère qui est actuellement utilisé dans l'analyse des réseaux dans les applications critiques.

L'aéronef 500 représenté sur la Fig.5 comporte un exemple d'implémentation de réseau électrique 501 mettant en oeuvre l'invention. Le réseau électrique comprend au moins deux convertisseurs bidirectionnels, un premier et un second, montés en cascade. Ces convertisseurs bidirectionnels peuvent être, tour à tour, source et charge l'un vis-à-vis de l'autre. Chacun des convertisseurs bidirectionnels étant équipé, en entrée et en sortie, d'un filtre de mode différentiel selon l'invention, les actions sur les interrupteurs respectifs de ces différents filtres de mode différentiel permet d'assurer que l'impédance de sortie du convertisseur bidirectionnel source, est inférieure à l'impédance d'entrée du convertisseur bidirectionnel charge. Ainsi, si un premier des deux convertisseurs bidirectionnels est en mode source (ie : le second est en mode charge), l'interrupteur sur son filtre de mode différentiel associé en sortie sera fermé, tandis que l'interrupteur sur le filtre de mode différentiel associé en entrée au second des deux convertisseurs sera fermé. Quand le second des deux convertisseurs bidirectionnels est en mode source (ie : le premier est en mode charge), l'interrupteur sur son filtre de mode différentiel associé en sortie sera fermé, tandis que l'interrupteur sur le filtre de mode différentiel associé en entrée au premier des deux convertisseurs sera fermé.

Des modifications et des améliorations aux mises en œuvre décrites ci-dessus de la présente invention peuvent apparaître à l'homme du métier. La description ci-dessus est illustrative au travers d'exemples plutôt que limitative. La portée de la présente invention est donc limitée uniquement par la portée des revendications ci-dessous.

## Revendications

1. Réseau électrique (501) comprenant deux convertisseurs bidirectionnels, un premier et un second, montés en cascade, le premier et le second convertisseur bidirectionnel étant électriquement reliés à respectivement un premier et un second filtre de mode différentiel, le premier filtre de mode différentiel étant électriquement relié au second filtre de mode différentiel, chacun du premier et du deuxième filtre de mode différentiel comprenant une inductance variable, l'inductance variable comprenant un enroulement primaire (101) couplé à un enroulement secondaire (102), l'enroulement secondaire comprenant un interrupteur (103) monté en série, configurés pour que :

   - lorsque l'interrupteur est en position fermée, l'inductance variable a une première valeur d'inductance, et lorsque l'interrupteur est en position ouverte, l'inductance variable a une seconde valeur d'inductance; et
   - la première valeur d'inductance est inférieure à la seconde valeur d'inductance,

   dans lequel un premier et un second interrupteur de respectivement le premier et le second filtre de mode différentiel sont configurés pour que :

   - lorsque le premier convertisseur bidirectionnel est en mode source, et le second convertisseur en mode charge : le premier interrupteur est fermé, et le second interrupteur est ouvert; et
   - lorsque le second convertisseur est en mode source, et le premier convertisseur en mode charge : le second interrupteur est fermé, et le premier interrupteur est ouvert,

   de façon à assurer que l'impédance de sortie du convertisseur bidirectionnel en mode source, est inférieure à l'impédance d'entrée du convertisseur bidirectionnel en mode charge.

2. Réseau électrique de la revendication 1, dans lequel l'enroulement secondaire d'au moins l'un du premier ou du deuxième filtre comprend en outre une première impédance additionnelle (401$_a$) en série avec l'interrupteur (103).

3. Réseau électrique de la revendication 2, dans lequel l'enroulement secondaire d'au moins l'un du premier ou du deuxième filtre comprend en outre une seconde impédance additionnelle (402) en parallèle avec l'interrupteur (103) et la première impédance additionnelle.

4. Réseau électrique selon l'une des revendications 1 à 3, dans lequel l'interrupteur d'au moins l'un du premier ou du deuxième filtre est bidirectionnel.

5. Réseau électrique selon l'une des revendications 1 à 3, dans lequel l'interrupteur d'au moins l'un du premier ou du deuxième filtre est de type électronique.

6. Aéronef (500) comprenant le réseau électrique (501) selon l'une des revendications 1 à 5.

**Fig. 1**

**Fig. 2**

Fig. 3

# Fig. 4

# Fig. 5

**EP 4 701 058 A1**

Europäisches Patentamt
European Patent Office
Office européen des brevets

# RAPPORT DE RECHERCHE EUROPEENNE

Numéro de la demande

EP 25 19 4187

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CN 203 933 404 U (SHANGHAI YINGTONG ELECTRIC CO LTD) 5 novembre 2014 (2014-11-05) * figure 1 * | 1-6 | INV. H02M1/12 H03H7/09 |
| Y | EP 3 244 520 B1 (ROCKWELL AUTOMATION TECH INC [US]) 18 août 2021 (2021-08-18) * figures 1-12 * * alinéa [0008] - alinéa [0010] * | 1-6 | |
| Y | GB 2 520 584 A (CAMBRIDGE SILICON RADIO LTD [GB]) 27 mai 2015 (2015-05-27) * page 14 - page 15; figure 9 * | 1-6 | |
| Y | EP 2 066 103 B1 (ALCATEL LUCENT [FR]) 1 mars 2017 (2017-03-01) * figure 2 * * alinéa [0039] - alinéa [0040] * | 1-6 | |
| A | EP 3 952 085 A1 (SIEMENS AG [DE]) 9 février 2022 (2022-02-09) * figures 1-13 * | 2,3 | DOMAINES TECHNIQUES RECHERCHES (IPC) |
| A | EP 2 048 771 A1 (SCHNEIDER TOSHIBA INVERTER [FR]) 15 avril 2009 (2009-04-15) * figure 7 * | 2,3 | H02M H03H |

Le présent rapport a été établi pour toutes les revendications

| Lieu de la recherche | Date d'achèvement de la recherche | Examinateur |
|---|---|---|
| La Haye | 23 décembre 2025 | Madouroglou, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

    .........................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 19 4187

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-12-2025

| Document brevet cité au rapport de recherche | | | Date de publication | Membre(s) de la famille de brevet(s) | | | Date de publication |
|---|---|---|---|---|---|---|---|
| CN 203933404 | U | | 05-11-2014 | AUCUN | | | |
| EP 3244520 | B1 | | 18-08-2021 | CN | 107370348 | A | 21-11-2017 |
| | | | | EP | 3244520 | A1 | 15-11-2017 |
| | | | | US | 2017324333 | A1 | 09-11-2017 |
| GB 2520584 | A | | 27-05-2015 | DE | 102014013479 | A1 | 03-06-2015 |
| | | | | GB | 2520584 | A | 27-05-2015 |
| EP 2066103 | B1 | | 01-03-2017 | AUCUN | | | |
| EP 3952085 | A1 | | 09-02-2022 | CN | 116114156 | A | 12-05-2023 |
| | | | | EP | 3952085 | A1 | 09-02-2022 |
| | | | | EP | 4150750 | A1 | 22-03-2023 |
| | | | | US | 2023318439 | A1 | 05-10-2023 |
| | | | | WO | 2022028754 | A1 | 10-02-2022 |
| EP 2048771 | A1 | | 15-04-2009 | EP | 2048771 | A1 | 15-04-2009 |
| | | | | FR | 2902247 | A1 | 14-12-2007 |
| | | | | JP | 5090068 | B2 | 05-12-2012 |
| | | | | JP | 2007329930 | A | 20-12-2007 |
| | | | | US | 2007296374 | A1 | 27-12-2007 |

EPO FORM P0460

Pour tout renseignement concernant cette annexe : voir Journal Officiel de l'Office européen des brevets, No.12/82